## Europäisches Patentamt
## European Patent Office
## Office européen des brevets

(19)

(11) Veröffentlichungsnummer: **0 033 506**
**B1**

(12) # EUROPÄISCHE PATENTSCHRIFT

(45) Veröffentlichungstag der Patentschrift:
**16.05.84**

(51) Int. Cl.³: **C 23 C 13/02,** H 01 B 5/14

(21) Anmeldenummer: **81100556.0**

(22) Anmeldetag: **26.01.81**

(54) **Verfahren zum Herstellen niederohmiger, einkristalliner Metall- oder Legierungsschichten auf Substraten.**

(30) Priorität: **30.01.80 DE 3003285**

(43) Veröffentlichungstag der Anmeldung:
**12.08.81 Patentblatt 81/32**

(45) Bekanntmachung des Hinweises auf die Patenterteilung:
**16.05.84 Patentblatt 84/20**

(84) Benannte Vertragsstaaten:
**CH FR GB IT LI NL**

(56) Entgegenhaltungen:
**DD - A - 115 708**
**DE - A - 1 614 814**
**DE - A - 2 612 098**
**DE - B - 2 146 662**
**DE - B - 2 647 566**

(73) Patentinhaber: **SIEMENS AKTIENGESELLSCHAFT,**
**Berlin und München Wittelsbacherplatz 2,**
**D-8000 München 2 (DE)**

(72) Erfinder: **Hieber, Konrad, Dr., Aiblingerstrasse 3,**
**D-8000 München 19 (DE)**
Erfinder: **Mayer, Norbert, Dr., Höglwörtherstrasse 216,**
**D-8000 München 70 (DE)**

## Verfahren zum Herstellen niederohmiger, einkristalliner Metall- oder Legierungsschichten auf Substraten

Die vorliegende Patentanmeldung betrifft ein Verfahren zum Herstellen niederohmiger, einkristalliner Metall- oder Legierungsschichten auf Substraten, wie sie insbesondere in der Halbleiter- und Dünnschichttechnologie Anwendung finden.

Metall- oder Legierungsschichten auf Substraten aus Keramik, Glas oder Silizium werden in der Elektrotechnik vielfach verwendet. Solche dünnen Metallschichten dienen beispielsweise als Leiterbahnstrukturen, elektrische Widerstände oder Kondensatoren in der Halbleiter- oder Dünnschichttechnologie.

Die fortschreitende Miniaturisierung in der Halbleitertechnologie bringt eine Verringerung des Querschnitts der Leiterbahnen mit sich. Dabei wird das Verhältnis Höhe zu Breite der Leiterbahn wesentlich größer, so daß die Wärmeabfuhr über das Substrat schlechter wird, d. h., die Leiterbahn wird einer höheren Temperaturbelastung ausgesetzt. Da sich auch die Stromstärken nicht proportional zum Leiterbahnquerschnitt verringern lassen, muß mit Stromdichten von $1 \cdot 10^6$ bis $1 \cdot 10^8$ A/cm$^2$ gerechnet werden. Sowohl die höhere Wärmebelastung als auch höhere Stromdichten beschleunigen den Ausfall von Leiterbahnen durch Elektromigration. Die Hauptursache der Elektromigration ist in Materialinhomogenitäten, z. B. Korngrenzen zu suchen.

Aufgabe der vorliegenden Erfindung ist es, niederohmige ($\rho < 15 \, \mu\Omega$ cm), einkristalline Metall- oder Legierungsschichten herzustellen, wobei für die Herstellung der einkristallinen Leiterbahnen keine Temperaturen über 350° C benötigt werden. Der Begriff einkristallin bedeutet in diesem Zusammenhang, daß der mittlere Korndurchmesser k wesentlich größer ist als die Schichtdicke d ($k \geq 100 \cdot d$), jedoch mindestens die Größe z. B. eines Transistors in einem System erreicht ($k \approx 50 \, \mu m$).

Bisher wurde das Problem der Elektromigration so gelöst, daß man sich auf niederohmige Materialien ($\rho < 15 \, \mu\Omega$ cm) und Stromdichten von maximal $5 \cdot 10^5$ A/cm$^2$ beschränkt hat. Da der Effekt der Elektromigration am größten ist, wenn k etwa der Breite der Leiterbahnen entspricht, bieten sich zwei Möglichkeiten an:

1.  Herstellung von feinkristallinen Materialien. Ideal wäre ein stabiles amorphes Material, welches aber wegen des zwangsläufig hohen spezifischen elektrischen Widerstandes kaum Verwendung finden dürfte. Aus diesem Grund wird ein Kompromiß getroffen, bei dem z. B. Aluminium mit 1,2 bis 2% Silizium und/oder maximal 4% Kupfer legiert wird. Diese relativ geringen Mengen an Fremdatomen erhöhen den spezifischen elektrischen Widerstand nur geringfügig; im Vergleich zu reinem Aluminium stabilisieren sie das Gefüge des Leiterbahnmaterials, so daß im Endeffekt eine Verbesserung des Langzeitverhaltens resultiert (nähere Einzelheiten siehe D. R. Denison, L. D. Hartsough, Technical Report, 79.02, Perkin Elmer Ultek Division.).

2.  Herstellung von einkristallinen Schichten. Untersuchungen von d'Heurle (J. Ames, Appl. Phys. Let., 16 (1970) 80—81) haben gezeigt, daß einkristallines Aluminium in seiner Langzeitstabilität und Resistenz gegenüber Elektromigration allen zukünftigen Anforderungen genügen würde. Das Problem ist, daß die Herstellung dieser einkristallinen Aluminiumschichten bisher nur auf einkristallinen Substraten bei Temperaturen über 350° C möglich ist.

Ein Verfahren, bei dem einkristalline Schichten erhalten werden, ohne daß Temperaturen über 350° C erforderlich sind, ist aus der DOS 27 27 659 bekannt. Bei diesem Verfahren werden stabile Schichteigenschaften dadurch erzielt, daß die vorzugsweise aus Tantal bestehenden Metallschichten bei tiefer Substrattemperatur in amorpher bzw. stark gestörter Form, z. B. bei −190° C auf dem Substrat niedergeschlagen werden und anschließend durch vergleichsweise geringe Erwärmung des Substrats zur Kristallisation gebracht werden. Auf diese Weise werden kohärente Gitterbereiche von kleiner 4 nm bei Erwärmen des Substrates über ca. −90° C auf Kristalle mit einem Korndurchmesser von mindestens 70 μm vergrößert. Diese Schichten behalten auch bei sehr viel höheren Temperaturen (höher als 400° C) ihre Eigenschaften bei, obwohl sie beim Herstellvorgang keiner höheren Temperatur als −90° C ausgesetzt waren. Dieses Verfahren ist im Rahmen der Halbleiter- und Dünnschichttechnologie einsetzbar, hat aber bisher nur bei Tantal, Tantal-Kobalt und Wolfram-Kupfer zu Schichten mit $k \approx 100 \cdot d$ geführt. Der spezifische elektrische Widerstand dieser Schichten liegt auch nach der Kristallisation über 15 μΩ cm.

Die Erfindung löst die gestellte Aufgabe der Herstellung niederohmiger ($\rho < 15 \, \mu\Omega$ cm), einkristalliner Metallschichten mit $k > 100 \cdot d$, dadurch, daß die Metall- oder Legierungsschicht zunächst im polykristallinen Zustand auf dem Substrat niedergeschlagen wird, wobei gleichzeitig oder unmittelbar danach durch Implantation von für die Metall- oder die Legierung inerten Ionen eine Kristallgitterstörung in der Schicht erzeugt wird und daß dann durch Erwärmen des Substrats bis maximal 350° C die stark gestörte polykristalline Schicht in den einkristallinen Zustand übergeführt wird.

Vorzugsweise wird das Substrat nach der Beschichtung auf Zimmertemperatur erwärmt.

Durch den Ionenbeschuß wird in dem, im polykristallinen Ausgangszustand vorliegenden Material ein für die Erzeugung einkristalliner Schichten notwendiger stark gestörter Ausgangszustand des Kristallgitters erzielt. Wesentlich ist, daß die implantierten Ionen beim Erwärmen des beschichteten Substrates bis maximal 350° C nicht mit dem Wirtsmetall reagieren.

Die Maßnahme des Ionenbeschusses kann in einer Weiterbildung des Erfindungsgedankens bei Materialien, deren Gitterfehler leicht ausheilen (z. B. Aluminium, Kupfer, Molybdän, Gold, Nickel) mit einer Substratkühlung, vorzugsweise auf Temperaturen unterhalb −90° C gekoppelt sein. Bei den meisten Legierungsschichten erübrigt sich jedoch die Maßnahme der Substratkühlung. Damit besteht der Vorteil, daß man bei der Auswahl des Metalles nur noch an die Forderung des einphasigen Endzustandes und an einen spezifischen Widerstand < 15 μΩ cm gebunden ist.

Folgende Materialien lassen sich nach dem Verfahren nach der Lehre der Erfindung als einkristallines Leiterbahnmaterial verwenden: Aluminium, Kupfer, Molybdän, Silber, Kupfer-Nickel, Aluminium-Kupfer mit 1 bis 20 Atom-% Aluminium, Silber-Gold, Silber-Palladium, Gold-Kupfer, Gold-Palladium, Chrom-Molybdän.

Als implantierte Ionen werden Stickstoff-, Wasserstoff- und/oder Edelgasatome verwendet, letztere vorzugsweise bei der Herstellung von Tantal- und Aluminium/Kupfer-Schichten. Bei der Chrombeschichtung werden insbesondere Stickstoffatome implantiert.

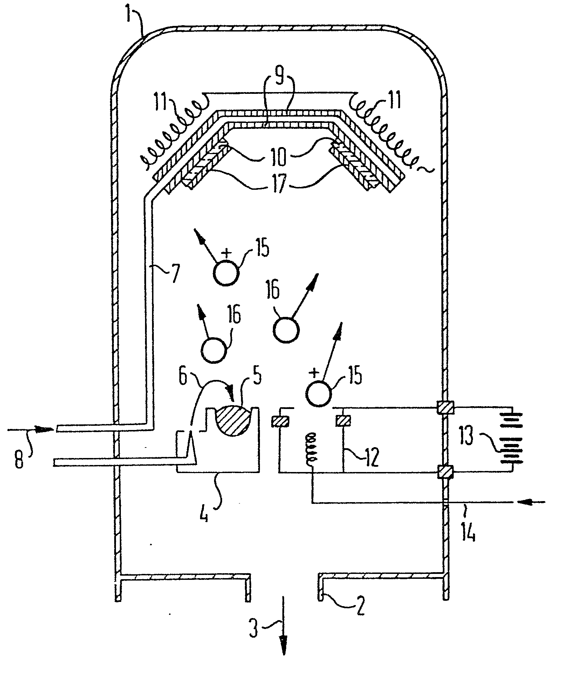

Im folgenden wird die Erfindung an Hand eines Ausführungsbeispiels und der in der Zeichnung befindlichen Figur noch näher erläutert.

Die Figur zeigt eine Bedampfungsanordnung, welche gemäß der Lehre der Erfindung mit einer Ionenimplantationseinrichtung kombiniert ist. In einer Vakuumkammer 1, die über einen Anschluß 2 mit einer Hochvakuumpumpe (siehe Pfeil 3) verbunden ist, befindet sich eine Elektronenstrahlverdampfungsquelle 4, welche eine Metallschmelze 5, beispielsweise aus einer Aluminiumkupferlegierung enthält. Durch einen Elektronenstrahl 6 wird diese bei einem Druck von z. B. $10^{-6}$ N/m² verdampft. In der Vakuumkammer 1 befindet sich auch eine Kühlvorrichtung 7, durch die ein Kühlmittel (siehe Pfeil 8) beispielsweise flüssiger Wasserstoff oder Stickstoff geleitet werden kann. Auf dieser Kühlvorrichtung 7 ist der Substrathalter 9 angeordnet. Darauf befinden sich die für die Beschichtung vorgesehenen Substrate 10, welche z. B. aus Keramik, Glas oder Silizium bestehen. Diese Substrate 10 sind mittels Widerstandsheizung 11 bis auf Temperaturen bis maximal 350° C aufheizbar.

Des weiteren ist in der Vakuumkammer 1 im Bereich des Elektronenstrahlverdampfers 4 eine Ionenkanone 12 angeordnet, welche an eine Hochspannungsversorgung 13 angeschlossen ist. Im Bereich dieser Ionenkanone 13 befindet sich der Gaseinlaß 14 für das aus den zu implantierenden Ionen bestehenden Inertgas. Bei einer Aluminium-Kupferbeschichtung (Aluminiumgehalt 6−12 Atom-%) besteht das Inertgas aus Argon. In der Figur sind die erzeugten Inertgasionen mit dem Bezugszeichen 15 bezeichnet, während die gleichzeitig aus dem Elektronenstrahlverdampfer 4 kommenden Metallatome mit dem Bezugszeichen 16 gekennzeichnet sind.

Wenn die Implantation der Inertgasionen während der Beschichtung durchgeführt wird, wird eine Implantationsenergie im Bereich von 5 keV bis 70 keV und eine Dosis im Bereich von $10^{13}$ bis $10^{16}$ Ionen cm$^{-2}$ sec$^{-1}$ je nach Materialauswahl eingestellt. Die Aufdampfrate beträgt bei einer Endschichtdicke von z. B. 3 μm 0,5 nm bis 5 nm/sec.

Es ist aber auch möglich, die Implantation der Inertgasatome nach der Beschichtung vorzunehmen. In diesem Fall wird die Energie auf 1 bis 5 MeV und die Implantationsdosis auf $10^{16}$ bis $10^{19}$ cm$^{-2}$ sec$^{-1}$ eingestellt.

Im Anschluß an die Beschichtung (Aufdampfrate 1 nm/sec), welche auch auf einem durch die Kühlvorrichtung 7 bis −190° C gekühlten Substrat 10 erfolgen kann, erfolgt nach Abschaltung des Elektronenstrahlverdampfers 4 und der Ionenimplantationsanordnung 12 eine Aufheizung des Substrates 10 mittels der Widerstandsheizung 11 auf 150° C, wobei die durch die Ionenimplantation (15) im Gitterbau stark gestörte Schicht 17 auf dem amorphen Substrat 10 in den einkristallinen Zustand übergeführt wird. Dabei ist der erzielte mittlere Korndurchmesser k wesentlich größer als die Schichtdicke d ($k \approx 200 \cdot d$). Der spezifische elektrische Widerstand der oben genannten Aluminium/Kupfer-Schichten liegt dann im Bereich von 8 bis 12 μΩ cm (d. h. $\rho < 15$ μΩ cm). Die Schichtdicke beträgt 3 μm.

## Patentansprüche

1. Verfahren zum Herstellen niederohmiger, einkristalliner Metall- oder Legierungsschichten auf Substraten, wie sie insbesondere in der Halbleiter- und Dünnschichttechnologie Anwendung finden, dadurch gekennzeichnet, daß die Metall- oder Legierungsschicht zunächst im polykristallinen Zustand auf dem Substrat niedergeschlagen wird, wobei gleichzeitig oder unmittelbar danach durch Implantation von für das Metall oder die Legierung inerten Ionen eine Kristallgitterstörung in der Schicht erzeugt wird und daß dann durch Erwärmen des Substrats bis maximal 350° C die stark gestörte polykristalline Schicht in den einkristallinen Zustand übergeführt wird.

2. Verfahren nach Anspruch 1, dadurch gekennzeichnet, daß bei dem Niederschlagen der Metall- oder Legierungsschicht das Substrat auf Temperaturen unterhalb −90° C gehalten wird.

3. Verfahren nach Anspruch 1 oder/und 2, dadurch gekennzeichnet, daß als implantierte Ionen Stickstoff-, Wasserstoff- und/oder Edelgasatome verwendet werden.

4. Verfahren nach mindestens einem der Ansprüche 1 bis 3, dadurch gekennzeichnet, daß bei der Herstellung von Chromschichten Stickstoffatome, von Tantal- und Aluminium-Kupfer-Schichten Edelgasatome implantiert werden.

5. Verfahren nach mindestens einem der Ansprüche 1 bis 4, dadurch gekennzeichnet, daß das Substrat nach der Beschichtung auf Zimmertemperatur erwärmt wird.

6. Verfahren nach mindestens einem der Ansprüche 1 bis 5, dadurch gekennzeichnet, daß die Beschichtung durch einen Elektronenstrahlverdampfer erfolgt.

7. Verfahren nach mindestens einem der Ansprüche 1 bis 6, dadurch gekennzeichnet, daß die Aufdampfrate pro Sekunde auf 0,5 nm bis 5 nm und die Schichtdicke auf 3 μm eingestellt wird.

8. Verfahren nach mindestens einem der Ansprüche 1 bis 7, dadurch gekennzeichnet, daß eine Energie von 5 keV bis 70 keV und eine Dosis von $10^{13}$ bis $10^{16}$ Ionen cm$^{-2}$ sec$^{-1}$ eingestellt wird, wenn die Implantation während des Beschichtens durchgeführt wird.

9. Verfahren nach mindestens einem der Ansprüche 1 bis 7, dadurch gekennzeichnet, daß eine Energie von 1 bis 5 MeV und eine Dosis von $10^{16}$ bis $10^{19}$ cm$^{-2}$ sec$^{-1}$ eingestellt wird, wenn die Implantation nach der Beschichtung durchgeführt wird.

## Claims

1. A process for the production of low-resistance, monocrystalline metal or alloy layers on substrates, such as are in particular used in semiconductor and thin-layer technology, characterized in that the metal or alloy layer is first deposited on the substrate in the polycrystalline state, a crystal-lattice disturbance being simultaneously or immediately thereafter produces in the layer by implantation of ions which ar inert towards the metal or alloy; and that by heating the substrate to at most 350° C, the highly disturbed polycrystalline layer is then converted into the monocrystalline state.

2. A process according to claim 1, characterized in that, during the deposition of the metal or alloy layer, the substrate is maintained at temperatures below −90° C.

3. A process according to claim 1 or/and claim 2, characterized in that nitrogen, hydrogen and/or noble gas atoms are used as implanted ions.

4. A process according to at least one of claims 1 to 3, characterized in that, for the production of chromium layers, nitrogen atoms are implanted, and for the production of tantalum and aluminium-copper layers noble gas atoms are implanted.

5. A process according to at least one of claims 1 to 4, characterized in that the substrate is heated to room temperature after coating.

6. A process according to at least one of claims 1 to 5, characterized in that the coating is effected by an electron beam vaporizer.

7. A process according to at least one of claims 1 to 6, characterized in that the vapour deposition rate per second is set at 0,5 mm to 5 mm, and the layer thickness is set at 3 μm.

8. A process according to at least one of claims 1 to 7, characterized in that an energy of 5 keV to 70 keV and a dosage of $10^{13}$ to $10^{16}$ ions cm$^{-2}$ sec$^{-1}$ are set, if the implantation is carried out during the coating step.

9. A process according to at least one of claims 1 to 7, characterized in that an energy of 1 to 5 MeV and a dosage of $10^{16}$ to $10^{19}$ cm$^{-2}$ sec$^{-1}$ are set, if the implantation is carried out after the coating step.

## Revendications

1. Procédé pour fabriquer des couches monocristallines de faible valeur ohmique en métal ou en alliage sur des substrats, du type utilisable notamment dans la technologie des semiconducteurs et dans la technologie des couches minces, caractérisé par le fait qu'on dépose la couche de métal ou d'alliage tout d'abord à l'état polycristallin sur le substrat, en produisant simultanément ou aussitôt après une perturbation du réseau cristallin dans la couche par implantation d'ions inertes pour le métal ou l'alliage, et qu'on amène ensuite la couche polycristalline fortement perturbée, à l'état monocristallin au moyen d'un chauffage du substrat jusqu'à une température égale au maximum à 350° C.

2. Procédé suivant la revendication 1, caractérisé par le fait que dans le cas du dépôt de la couche de métal ou d'alliage, on maintient le substrat à des températures inférieures à −90° C.

3. Procédé suivant la revendication 1 et/ou 2, caractérisé par le fait qu'on utilise comme ions implantés, des atomes d'azote, des atomes d'hydrogène et/ou des atomes de gaz rares.

4. Procédé suivant au moins l'une des revendications 1 à 3, caractérisé par le fait que dans le cas de la fabrication de couches de chrome on implante des atomes d'azote et que dans le cas de la fabrication de couches de tantale et d'aluminium-cuivre on implante des atomes de gaz rares.

5. Procédé suivant au moins l'une des revendications 1 à 4, caractérisé par le fait qu'après le dépôt de la couche, on chauffe le substrat à la température ambiante.

6. Procédé suivant au moins l'une des revendications 1 à 5, caractérisé par le fait que le dépôt de la couche s'effectue au moyen d'un évaporateur à faisceau électronique.

7. Procédé suivant au moins l'une des revendications 1 à 6, caractérisé par le fait qu'on règle la vitesse de dépôt par évaporation par seconde à une valeur comprise entre 0,5 et 5 nm et qu'on règle l'épaisseur de la couche à 3 μm.

8. Procédé suivant au moins l'une des revendications 1 à 7, caractérisé par le fait qu'on règle une énergie comprise entre 5 keV et 70 keV et une dose de $10^{13}$ à $10^{16}$ ions cm$^{-2}$ s$^{-1}$, lorsque

l'implantation est réalisée pendant le dépôt de la couche.

9. Procédé suivant au moins l'une des revendications 1 à 7, caractérisé par le fait qu'on règle une énergie comprise entre 1 à 5 MeV et une dose comprise entre $10^{16}$ et $10^{19}$ cm$^{-2}$ s $^{-1}$, lorsque l'implantation est réalisée après le dépôt de la couche.